# EUROPEAN PATENT APPLICATION

(11) **EP 4 156 315 A1**
(43) Date of publication of application: **29.03.2023**
(21) Application number: 21808513.2
(22) Date of filing: 29.04.2021
(51) Int. Cl.: H01L 51/52, H01L 51/00, G09F 9/30, F16C 11/04, G06F 1/16

(54) **ELASTIC MEMBER**

(30) Priority: 19.05.2020 KR 20200059857; 19.05.2020 KR 20200059882
(71) Applicant: LG Innotek Co., Ltd., Seoul 07796 (KR)
(72) Inventor: PARK, Duck Hoon, Seoul 07796 (KR); KANG, Sung Won, Seoul 07796 (KR); GWAK, Jung Min, Seoul 07796 (KR)
(74) Representative: Plasseraud IP
(86) International application number: PCT/KR2021/005411
(87) International publication number: WO 2021/235725

(57) **Abstract**

Proposed is an elastic member capable of ensuring folding reliability and preventing deformation of a substrate, the elastic member comprising: a first surface; and a second surface opposite to the first surface, wherein the elastic member includes a first area and a second area, wherein the first area comprises: a first pattern portion in which a plurality of first patterns are arranged extending in a first direction; and a second pattern portion in which a plurality of second patterns are arranged extending in the first direction and which partially overlaps with the first pattern portion in a second direction different from the first direction, and the second area comprises: a third pattern portion in which a plurality of third patterns are arranged extending in the first direction; and a fourth pattern portion in which a plurality of fourth patterns are arranged extending in the first direction and which partially overlaps with the third pattern portion in the second direction different from the first direction.

## Description

### [Technical Field]

An embodiment relates to an elastic member.

### [Background Art]

Recently, there is an increasing demand for a flexible or foldable display device capable of easily carrying various applications and displaying an image on a large screen when being carried.

Such a flexible or foldable display device is folded or partially bent when being carried or stored, and may be implemented with the display unfolded when displaying images. Accordingly, an image display area may be increased, and a user may easily carry the display.

After the flexible or foldable display device is folded or bent, a restoration process of unfolding the flexible display device again may be repeated.

That is, since the flexible or foldable display device repeats folding and unfolding operations, the substrate of the flexible display device is required to have a certain strength and elasticity, and cracks and deformations should not occur in the substrate during folding and restoring.

Meanwhile, the substrate for display which is elastic member constituting a flexible or foldable display device generally uses a metal substrate.

Accordingly, the substrate for display including the metal may be subjected to compressive and tensile stresses in the folding area as folding and unfolding are repeated, and thus, cracks may occur in the folding area, thereby reducing reliability.

In order to prevent deformation of the elastic member due to such compressive and tensile stresses, a pattern part such as a hole or a groove may be formed in the elastic member.
a size, position, and arrangement of the pattern parts may be important in preventing the folding reliability and deformation of the substrate for display.

Accordingly, there is a need for an elastic member having a new structure capable of securing the folding reliability of the elastic member and preventing deformation of the elastic member.

### [Disclosure]

### [Technical Problem]

An embodiment is to provide an elastic member having improved reliability by controlling the size, position, and arrangement of pattern parts disposed in the folding area and the unfolding area.

### [Technical Solution]

An elastic member according to an embodiment includes a first surface and a second surface opposite to the first surface, and includes a first area and a second area, wherein the first area is defined as an unfolding area, and the second area is defined as a folding area, and the first area may include: a first pattern part in which a plurality of first patterns are disposed to extend in a first direction; and a second pattern part in which a plurality of second patterns are disposed extending in the first direction, and partially overlapping the first pattern part in a second direction different from the first direction, and the first pattern part and the second pattern part are disposed in the first area, a third pattern part and a fourth pattern part are disposed in the second area, and the first region includes a pattern area in which the first pattern part and the second pattern part are formed, and a non-patterned area disposed outside the pattern area and in which the first pattern part and the second pattern part are not formed.

### [Advantageous Effects]

An elastic member according to the embodiment may include a non-patterned area in which a pattern is not formed in the unfolding area.

Accordingly, the elastic member may maintain the strength of the elastic member by the non-patterned area. In detail, an area in which no pattern part, such as a hole or groove, is not formed, remains in the unfolding area, whereby the area of the elastic member in which the pattern part is not formed may be secured as a predetermined area. Thereby, the strength of the elastic member can be secured, and the supporting force of the elastic member supporting the panel or the like can be secured.

In addition, in the elastic member according to the embodiment, since the opening ratio per unit area is controlled in the folding area and the unfolding area, a sudden change in strength due to the difference in the opening ratio of the elastic member can be reduced. Accordingly, deformation such as cracks or warpage in the boundary area between the pattern area and the non-patterned area of the elastic member can be minimized.

Accordingly, the elastic member according to the embodiment may have improved folding reliability.

In addition, in the elastic member according to the embodiment, the protrusion formed by the area cut to the size of the unit area is formed while having a constant groove. Accordingly, in the process of manufacturing the elastic member with a size of a unit area, it is possible to easily control the alignment and the cutting position of the cutting area.

Accordingly, since the size of the protrusion remaining after cutting can be controlled, interference by the protrusion can be minimized when the elastic member and other members are coupled to each other after cutting.

### [Description of Drawings]

FIG. 1 is a perspective view of a flexible display device according to an embodiment.
FIG. 2 is a perspective view of an elastic member according to an embodiment.
FIG. 3 is a side view of the elastic member before folding according to an embodiment.
FIG. 4 is a side view of the elastic member after folding according to an embodiment.
FIG. 5 is a top view of a first surface of the elastic member according to the embodiment.
FIG. 6 is a top view of a second surface of the elastic member according to the embodiment.
FIGS. 7 and 8 are top views of the first surface of the elastic member for explaining an unfolding area of the elastic member according to an embodiment.
FIG. 9 is top view of the first surface of the elastic member for explaining a folding area of the elastic member according to an embodiment.
FIG. 10 is top view of the first surface of the elastic member for explaining a bridge part of the elastic member according to the embodiment.
FIG. 11 is top view of the first surface of the elastic member for explaining a protrusion of the elastic member according to the embodiment.
FIG. 12 is view for explaining a process in which the elastic member according to the embodiment is formed of the elastic member having a unit area.
FIGS. 13 and 14 are cross-sectional views taken along line A-A' in FIG. 12.
FIG. 15 is an enlarged views of area B in FIG. 11.
FIGS. 16 and 17 are cross-sectional views taken along line C-C' in FIG. 15.
FIG. 18 is a view for describing an example in which the elastic member according to an embodiment is applied.

### [Modes of the Invention]

Hereinafter, embodiments of the present invention will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and replaced.

In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

Hereinafter, an elastic member according to an embodiment will be described with reference to drawings.

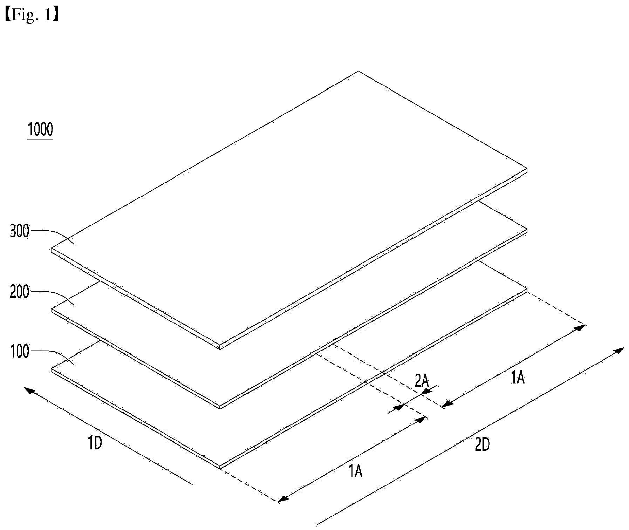

FIG. 1 is a perspective view of a display device including an elastic member according to an embodiment. The display device according to the embodiment may be a flexible display device or a foldable display device that can be bent in one direction.

Referring to FIG. 1, a display device 1000 according to an embodiment may include an elastic member 100, a display panel 200 disposed on the elastic member 100, and a touch panel 300 disposed on the display panel 200.

The elastic member 100 may support the display panel 200 and the touch panel 300. That is, the elastic member 100 may be a support substrate supporting the display panel 200 and the touch panel 300.

The elastic member 100 may include a material such as metal. For example, the elastic member 100 may include metal, metal alloy, plastic, a composite material (e.g., carbon fiber reinforced plastic, a magnetic or conductive material, a glass fiber reinforced material, etc.), ceramic, sapphire, glass, and the like. The elastic member 100 may be formed as a single layer or as a multilayer including a plurality of layers.

The elastic member 100 may be flexible or foldable. That is, the elastic member 100 may be folded or bent in one direction. That is, the elastic member 100 may be a substrate for display applied to a flexible display device or a foldable display device.

The elastic member 100 may be defined in a first direction 1D and a second direction 2D that is different from the first direction 1D. For example, the first direction 1D may be defined as the same direction as the folding axis direction of the elastic member 100, and the second direction may be a direction perpendicular to the first direction.

Any one of the first direction 1D and the second direction 2D may be defined as a width direction of the elastic member 100, and the other direction may be defined as a longitudinal direction of the elastic member 100.

The elastic member 100 may be folded using any one of a width direction and a longitudinal direction of the elastic member 100 as a folding axis.

Hereinafter, for convenience of description, the first direction is defined as the same direction as the folding axis. In addition, the first direction is defined as a width direction of the elastic member 100, and the second direction is defined as a longitudinal direction of the elastic member 100.

The elastic member 100 may include at least two areas. In detail, the elastic member 100 may include a first area 1A and a second area 2A.

The first area 1A may be defined as an area where the elastic member 100 is not folded. That is, the first area 1A may be an unfolding area.

In addition, the second area 2A may be defined as an area where the elastic member 100 is folded. That is, the second area 1A may be a folding area.

The first area 1A and the second area 2A will be described in detail below.

The display panel 200 may be disposed above the elastic member 100.

The display panel 200 may include a plurality of pixels including a switching thin film transistor, a driving thin film transistor, a power storage device, and an organic light-emitting diode (OLED). In case of the OLED, deposition may be performed at a relatively low temperature, and the OLED may be mainly applied to a flexible display device for reasons such as low power and high luminance. Here, a pixel refers to a minimum unit for displaying an image, and the display panel displays an image through a plurality of pixels.

The display panel 200 may include a substrate, a gate line disposed on the substrate, a data line crossing with the gate line in isolation, and a common power line. In general, one pixel may be defined by the gate line, the data line, and the common power line as a boundary.

The substrate may include a material having flexible properties such as a plastic film, and the display panel 200 may be implemented by disposing an organic light-emitting diode and a pixel circuit on a flexible film.

The touch panel 300 may be disposed above the display panel 200. The touch panel 300 may implement a touch function in the flexible display device, and the touch panel may be omitted in the foldable display device that simply displays an image without the touch function.

The touch panel 300 may include a substrate and a touch electrode disposed on the substrate. The touch electrode may sense a position of an input device that is touched on the foldable of flexible display device using a capacitance type or a resistive film type.

The substrate of the touch panel 300 may include a material having flexible properties such as a plastic film, and the touch panel 300 may be implemented by disposing the touch electrode on the flexible film.

Meanwhile, the elastic member 100 and the display panel 200 may have different sizes.

For example, the area of the elastic member 100 may be 90% or more to 110% or less of the area of the display panel 200. In detail, the area of the elastic member 100 may be 95% or more to 105% or less of the area of the display panel 200. In more detail, the area of the elastic member 100 may be 97% or more to 100% or less of the area of the display panel 200.

When the area of the elastic member 100 is 90% or less of the area of the display panel 200, the supporting force of the elastic member 100 to support the display panel 200 or the touch panel 300 may be reduced. Accordingly, a curl may occur in the unfolding area of the elastic member 100. Accordingly, when the user visually recognizes the screen area, visibility may decrease. Also, when the touch is driven, a touch malfunction may occur because the screen of the touch area is incomplete due to the curl area.

An addition, when the area of the elastic member 100 is greater than 110% of the area of the display panel 200, a supporting force for supporting the display panel or the touch panel by the elastic member 100 may be secured. However, a bezel area of a display device including the substrate, the display panel, and the touch panel may increase. As a result, the screen area effective to the user is narrowed, which may be inconvenient when using the display device.

Meanwhile, although not shown in the drawings, a cover window for protecting the foldable display device or the flexible display device may be additionally disposed on the touch panel 300 or the display panel 200 (when the touch panel is omitted).

Meanwhile, the elastic member 100, the display panel 200, and the touch panel 300 may be adhered to each other through an adhesive layer or the like. In this case, when the elastic member 100 and the display panel 200 are bonded to each other, the adhesive layer is not disposed on the second area, that is, the folding area of the elastic member 100. The adhesive layer may be disposed only in the first area, that is, in the unfolding area, to be adhered to each other. Alternatively, the adhesive layer may be disposed on both the first region and the second region.

As described above, the display device includes the elastic member 100.

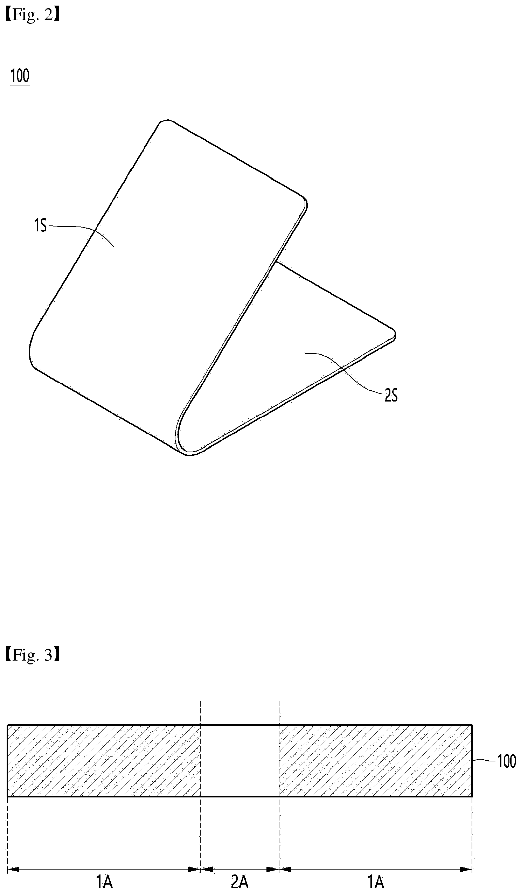

Referring to FIG. 2, the elastic member 100 may be bent in one direction.

In detail, the elastic member 100 may include a first surface 1S and a second surface 2S opposite to the first surface 1S. In the elastic member 100, the first surface 1S or the second surface 2S may be bent to face each other. That is, a surface on which the panels are disposed may be bent to face each other, or a surface opposite to the surface on which the panels are disposed may be bent to face each other.

In the following description, as shown in FIG. 2, it will be mainly described that the one surfaces 1S are bent in a direction facing each other in the elastic member 100.

As described above, the first area 1A and the second area 2A may be defined in the elastic member 100. The first area 1A and the second area 2A may be areas defined when the second surfaces 2S are bent in the direction facing each other in the elastic member 100.

In detail, the elastic member 100 is bent in one direction, and the elastic member 100 may be divided into the first area 1A which is an unfolded area (unfolding area) and the second area 2A which is a folded area (folding area).

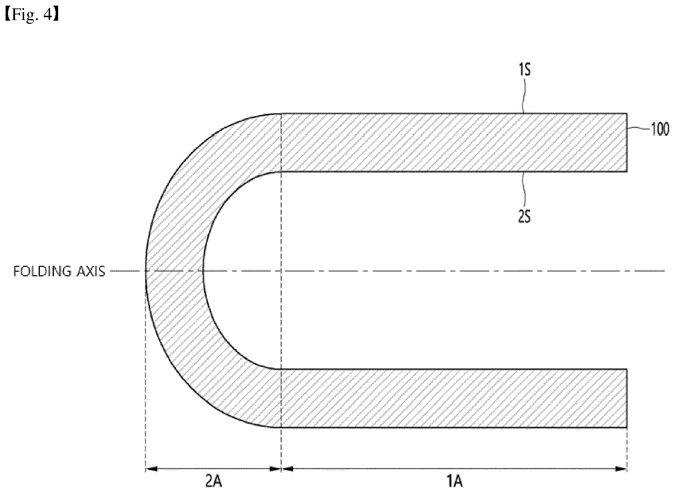

Referring to FIG. 3 and FIG. 4, the elastic member 100 may include the second area 2A that is an area where the elastic member 100 is bent. The elastic member 100 may include the first area 1A that is not bent and is disposed adjacent to the second area 2A.

For example, the first area 1A may be formed on the left side and the right side of the second area 2A based on the direction in which the elastic member 100 is bent. That is, the first area 1A may be disposed at both ends of the second area 2A. That is, the second area 2A may be disposed between the first areas 1A.

The first area 1A and the second area 2A may be formed on the same elastic member 100. That is, the first area 1A and the second area 2A may be formed integrally with each other without being separated on the same elastic member 100.

Sizes of the first area 1A and the second area 2A may be different from each other. In detail, the size of the first area 1A may be larger than the size of the second area 2A.

In addition, the area of the second area 2A of the elastic member 100 may be 1% or more to 30% or less of the total area of the elastic member 100. In detail, the area of the second area 2A of the elastic member 100 may be 5% or more to 20% or less of the total area of the elastic member 100. The area of the second area 2A of the elastic member 100 may be 10% or more to 15% or less of the total area of the elastic member 100.

When the area of the second region 2A of the elastic member 100 is less than 1% of the total area of the substrate 100, when folding and restoring the elastic member is repeated, a crack may be formed on a boundary surface between the folding area and the unfolding area. Accordingly, folding reliability of the elastic member 100 may be reduced.

In addition, when the area of the second area 2A of the elastic member 100 exceeds 30% of the total area of the elastic member 100, when the elastic member is folded, a curl may occur in the folding area of the display panel 200. Accordingly, when the user visually recognizes the screen area, visibility may decrease. Also, when the touch is driven, a touch malfunction may occur because the screen of the touch area is incomplete due to the curl area.

Although the drawing shows that the second area 2A is positioned at the central portion of the elastic member 100, the embodiment is not limited thereto. That is, the second area 2A may be located at one end and an end region of the elastic member 100. That is, the second area 2A may be positioned at one end and an end region of the elastic member 100 so that the size of the second region 2A is asymmetrical.

FIG. 4 is a side view of the elastic member after the elastic member is folded.

Referring to FIG. 4, the elastic member 100 may be folded in one direction around a folding axis. In detail, the second surface 2S may be folded in a direction facing each other along the folding axis.

As the elastic member 100 is folded in one direction, the first area 1A and the second area 2A may be formed on the elastic member 100. That is, the folding area formed by folding the elastic member 100 in one direction and the unfolding area positioned at both ends of the folding area may be formed in the elastic member 100.

The folding area may be defined as an area where a curvature R is formed, and the unfolded area may be defined as an area where the curvature R is not formed or the curvature is close to zero.

Referring to FIGS. 3 and 4, the elastic member 100 may be folded in one direction, and may be formed in the order of an unfolding area, a folding area, and an unfolding area.

A plurality of pattern parts for reducing and dispersing stress generated when the elastic member 100 is folded may be formed in at least one of the first area 1A and the second area 2A. The pattern parts will be described in detail below.

Meanwhile, although FIG. 4 illustrates that the second surfaces 2S of the elastic member 100 are folded to face each other, the embodiment is not limited thereto, and the first surfaces 1S may be folded to face each other.

In detail, the folding surface of the elastic member may vary according to the formation position of the pattern part formed on the elastic member 100 to be described below.

That is, the elastic member 100 may be folded so that surfaces of the elastic member 100 on which pattern parts are not formed face each other.

Hereinafter, the elastic member according to various embodiments will be described in detail with reference to the drawings.

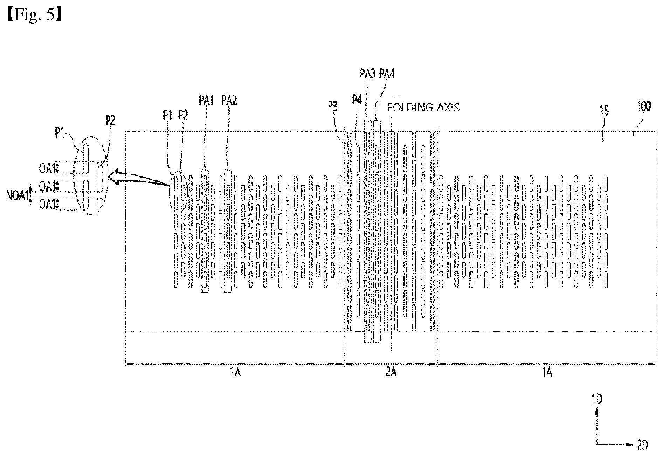

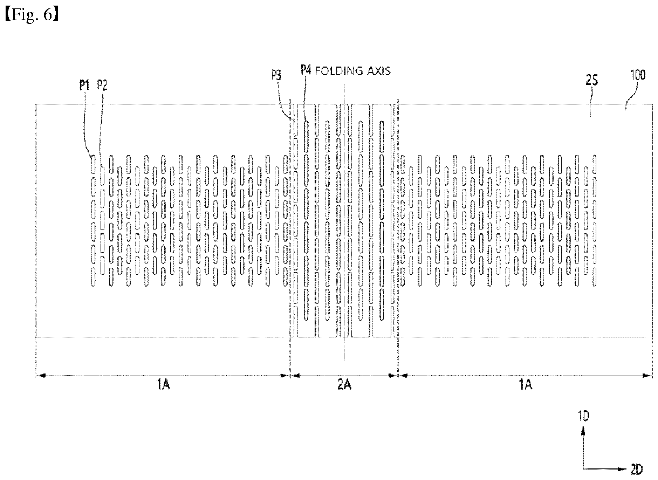

FIGS. 5 and 6 are top views of the first surface 1S and the second surface 2S of the elastic member according to the embodiment. That is, FIG. 5 is the top view of the first surface 1S of the elastic member, which is the outer surface of the folding, when the elastic member 100 is folded, and FIG. 6 is the top view of the second surface 2S of the elastic member, which is the inner surface of the folding, when the elastic member 100 is folded.

Referring to FIGS. 5 and 6, the elastic member 100 may include a plurality of pattern parts. In detail, a first pattern part PA1 and a second pattern part PA2 may be disposed in the first area 1A of the elastic member 100, and a third pattern part PA3 and a fourth pattern part PA4 may be disposed in the second area 2A of the elastic member 100.

In detail, the first area 1A may include the first pattern part PA1 in which a plurality of first patterns P1 are disposed while being spaced apart from each other and extending in the first direction 1D; and the second pattern part PA2 in which a plurality of second patterns P2 are disposed while being spaced apart from each other and extending in the first direction 1D, and partially overlap with the first pattern that is, the first pattern part PA1 at the second direction 2D different from the first direction 1D.

In addition, the second area 2A may include the third pattern part PA3 in which a plurality of third patterns P3 are disposed while being spaced apart from each other and extending in the first direction 1D; and the fourth pattern part PA4 in which a plurality of fourth patterns P4 are disposed while being spaced apart from each other and extending in the first direction 1D, and partially overlap with the third pattern that is, the third pattern part PA3 at the second direction 2D different from the first direction 1D

For example, at least one of the first pattern part PA1, the second pattern part PA2, the third pattern part PA3, and the fourth pattern part PA4 may extend in the same or similar direction to the folding axis.

That is, the first pattern part PA1 is defined as an aggregate of the first patterns P1, the second pattern part PA2 is defined as an aggregate of the second patterns P2, the third pattern part PA3 is defined as an aggregate of the third patterns P3, and the fourth pattern part PA4 is defined as an aggregate of the fourth patterns P4.

The first pattern P1, the second pattern P2, the third pattern P3, and the fourth pattern P4 may be formed in a hole shape penetrating the first surface 1S and the second surface 2S of the elastic member 100. Alternatively, the embodiment is not limited thereto, and the first pattern P1, the second pattern P2, the third pattern P3, and the fourth pattern P4 may be formed in a groove shape formed on first surface 1S or the second surface 2S of the elastic member 100.

That is, the first pattern P1, the second pattern P2, the third pattern P3, and the fourth pattern P4 may be all formed in a hole shape, may be all formed in a groove shape, or may be formed in a hole and groove shape.

Hereinafter, for convenience of description, the first pattern P1, the second pattern P2, the third pattern P3, and the fourth pattern P4 will be mainly described in the shape of a hole.

The first pattern P1, the second pattern P2, the third pattern P3, and the fourth pattern P4 may have curved surfaces. For example, the first pattern P1, the second pattern P2, the third pattern P3, and the fourth pattern P4 may be formed in a shape having a curved surface, such as an elliptical shape, a hemispherical shape, or a circular shape.

The first pattern part PA1 and the second pattern part PA2 may be alternately disposed. In detail, the first pattern part PA1 and the second pattern part PA2 may be alternately disposed while being spaced apart from each other in the second direction 2D.

That is, one second pattern part PA2 may be disposed between the two first pattern parts PA1, and one first pattern part PA1 may be disposed between the two second pattern parts PA2.

The first pattern part PA1 and the second pattern part PA2 may be disposed to be shifted from each other. For example, the first pattern P1 of the first pattern part PA1 and the second pattern P2 of the second pattern part PA2 may be disposed to partially overlap each other. In detail, the first pattern P1 of the first pattern part PA1 and the second pattern P2 of the second pattern part PA2 may partially overlap and may not partially overlap in the second direction.

That is, the first pattern P1 of the first pattern part PA1 may include an overlap area OA1 overlapping the second pattern P2 of the second pattern part PA2; and a non-overlap area NOA1 that does not overlap the second pattern P2 of the second pattern part PA2.

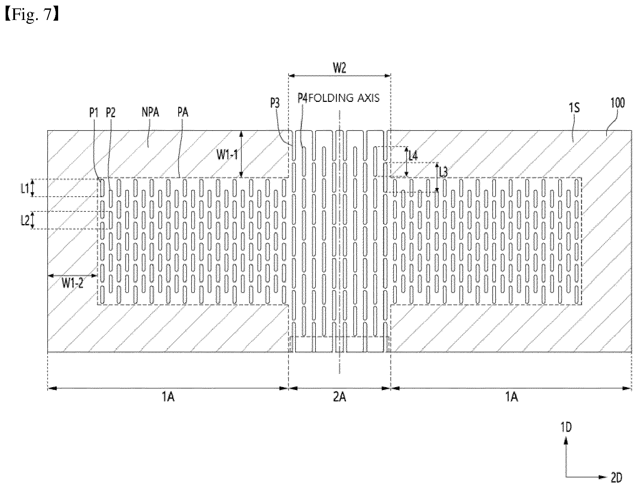

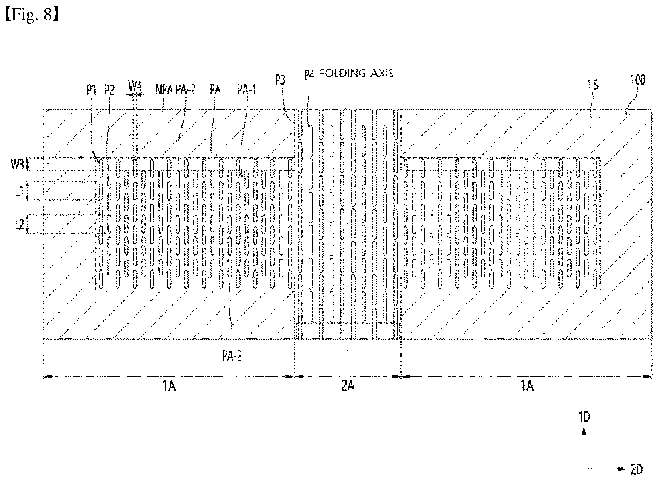

Referring to FIGS. 7 and 8, the first area 1A may be defined as two areas. In detail, the first area 1A may include a pattern area PA and a non-patterned area NPA disposed outside the pattern area PA depending on whether pattern parts are formed.

Referring to FIG. 7, the first pattern part PA1 and the second pattern part PA2 described above may be disposed in the pattern area PA. Also, a pattern part may not be formed in the non-patterned area NPA, and the first surface 1S and the second surface 2S of the elastic member 100 may be exposed.

An area of the pattern area PA may be different from an area of the non-patterned area NPA. In detail, the area of the pattern area PA may be larger than the area of the non-patterned area NPA. That is, in the first area 1A, which is the unfolding area, an area in which the pattern part is formed may be larger than an area in which the pattern part is not formed.

The pattern area PA formed in the first area 1A may improve the reliability of the elastic member 100.

In detail, a difference in deformation due to heat with the second area 2A in which the third pattern part PA3 and the fourth pattern part PA4 are disposed may be reduced by the pattern area PA. That is, since pattern parts are formed in both the first area 1A and the second area 2A, when heat is applied to the elastic member 100, a difference in deformation due to heat of the first area 1A and the second area 2A may be reduced. Accordingly, it is possible to prevent the elastic member 100 from being bent or twisted.

In addition, due to the third pattern part PA3 and the fourth pattern part PA4 formed in the first area 1A, a stress non-uniformity of the first area 1A and the second area 2A is reduced, whereby it is possible to prevent warping of the elastic member.

In addition, when a panel or the like is adhered to the elastic member 100 through an adhesive layer by the third pattern part PA3 and the fourth pattern part PA4 formed in the first area 1A, since the adhesive material is disposed while filling the inside of the first and second pattern parts of the first area 1A and the third and fourth pattern parts of the second area 2A together, whereby it is possible to prevent the adhesive layer from forming a step in the first area and the second area.

In addition, the elastic member 100 may maintain strength due to the non-patterned area NPA. In detail, an area in which no pattern part, such as a hole or groove, is formed remains in the first area 1A, whereby the area of the elastic member in which the pattern part is not formed may be secured as a predetermined area. Accordingly, the strength of the elastic member 100 may be secured, and the supporting force of the elastic member 100 supporting the panel or the like may be secured.

Meanwhile, a width of the non-patterned area NPA may be greater than a length of the first pattern P1 and the second pattern P2.

In detail, the non-patterned area NPA may include a first width W1-1 from one of both ends in the first direction 1D to the patterned area PA; and a second width W1-2 from one of both ends in the second direction to the pattern area PA.

In this case, at least one of the first width W1-1 and the second width W1-2 may be greater than the maximum length of any one of the first length L1 of the first pattern P1 and the second length L2 of the second pattern P2. For example, at least one of the first width W1-1 and the second width W1-2 may be greater than the first length L1 of the first pattern P1 and the second length L2 of the second pattern P2.

Here, the first length L1 and the second length L2 may be defined as maximum lengths of the first pattern P1 and the second pattern P2, respectively.

In detail, at least one of the first width W1-1 and the second width W1-2 may be greater than one time and less than or equal to five times of the first length L1 of the first pattern P1 and the second length L2 of the second pattern P2. In more detail, at least one of the first width W1-1 and the second width W1-2 may be greater than one time and less than or equal to four times of the first length L1 of the first pattern P1 and the second length L2 of the second pattern P2. In more detail, at least one of the first width W1-1 and the second width W1-2 may be two to three time of the first length L1 of the first pattern P1 and the second length L2 of the second pattern P2.

When at least one of the first width W1-1 and the second width W1-2 is smaller than the first length L1 of the first pattern P1 and the second length L2 of the second pattern P2, the area of the non-patterned portion in the second area 2A becomes too small, and thereby the strength and supporting force of the elastic member may be reduced.

In addition, when at least one of the first width W1-1 and the second width W1-2 exceeds 5 times the first length L1 of the first pattern P1 and the length of the second pattern P2, a difference in strength of the elastic member occurs in a boundary area between the pattern area PA and the non-patterned area NPA, whereby the elastic member may be bent, and when the elastic member is folded, stress may be concentrated in the boundary area and cracks may occur in the boundary area.

In addition, the number of pattern parts formed in the pattern area PA is reduced, and thus a difference in thermal deformation and a stress difference with the first area increases, thereby causing warpage, deformation, etc., in the elastic member. In addition, the area of the pattern area is increased to compensate for the bending and deformation as described above, so that the overall size of the elastic member may be increased.

Also, the first width W1-1 and the second width W1-2 may be different. For example, the first width W1-1 may be smaller than the second width W1-2.

Accordingly, when aligning the panel on the elastic member 100 through the reinforcing protrusion 150 to be described below, the elastic member and the panel may be easily aligned through the second width W1-2 having a wide width.

Also, at least one of the first width W1-1 and the second width W1-2 may be smaller than the width W2 of the second area 2A.

Accordingly, when the elastic member 100 is folded, the stress remaining in the elastic member 100 is minimized by the first width W1-1 and the second width W1-2 and thus the elastic member 100 can be easily folded.

In addition, at least one of the first width W1-1 and the second width W1-2 may be greater than the maximum length of any one of third length L3 of the third pattern P3 and the fourth length L4 of the fourth pattern P4. For example, at least one of the first width W1-1 and the second width W1-2 may be greater than the third length L3 of the third pattern P3 and a fourth length L3 of the fourth pattern P4.

Here, the third length L3 and the fourth length L4 may be defined as maximum lengths of the third pattern P3 and the fourth pattern P4, respectively.

Referring to FIG. 8, the pattern area PA of the first area 1A of the elastic member 100 may be defined as two areas. In detail, the pattern area PA of the first area 1A may include a first pattern area PA-1 and a second pattern area PA-2.

The first pattern P1 and the second pattern P2 may be disposed in the first pattern area PA-1. Also, the first pattern P1 or the second pattern P2 may be disposed in the second pattern area PA-2. In detail, the first pattern P1 may be only disposed in the second pattern area PA-2. In more detail, a portion of the first pattern P1 may be only disposed in the second pattern area PA-2.

An opening ratio per unit area of the first pattern area PA-1 may be different from an opening ratio per unit area of the second pattern area PA-2. Here, the opening ratio may be defined as an area of the first pattern and/or the second pattern formed in the pattern region.

In detail, the opening ratio per unit area of the first pattern area PA-1 may be greater than the opening ratio per unit area of the second pattern area PA-2.

That is, while extending from one end of the elastic member in the first direction to the first pattern area PA-1, the opening ratio per unit area of the elastic member may gradually increase.

In addition, a width W3 of the second pattern area PA-2 may be less than at least one of the first length L1 of the first pattern P1 and the second length L2 of the second pattern P2. Here, the first length L1 of the first pattern P1 and the second length L2 of the second pattern P2 may be defined the maximum of the first pattern P1 and the second pattern P2, respectively.

Also, the width W3 of the second pattern area PA-2 may be greater than a width of at least one of the widths W4 of the first pattern P1 and the second pattern P2. Here, the width of the first pattern P1 and the second pattern P2 may be defined as the maximum width of the first pattern P1 and the second pattern P2, respectively.

The second pattern area PA-2 is positioned between the non-patterned area NPA and the first pattern area PA-1. Accordingly, a sudden change in strength in a direction extending from one end of the elastic member in the first direction to the first pattern area PA1 may be reduced.

That is, while extending from one end of the elastic member in the first direction to the first pattern area PA-1, the difference in the opening ratio per unit area of the elastic member is formed to gradually increase. Accordingly, it is possible to reduce a change in strength due to a difference in the opening ratio. Accordingly, deformation such as cracks or warpage in the boundary area between the pattern area PA and the non-patterned area NPA may be minimized.

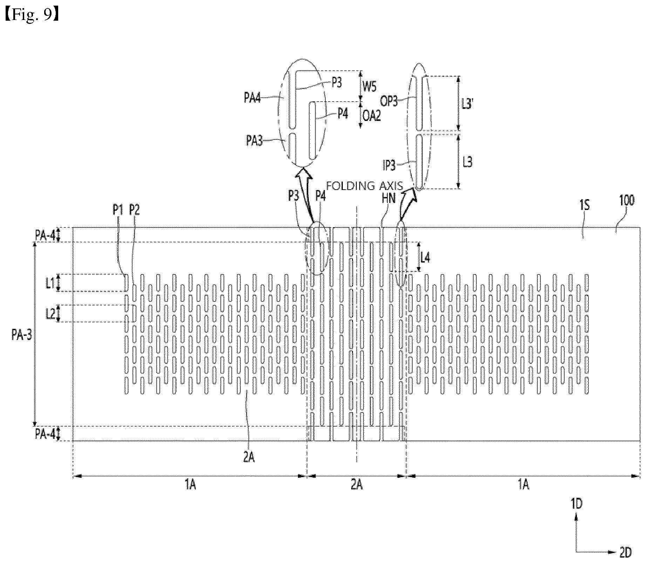

Referring to FIG. 9, the second area 2A may be defined as two areas. In detail, the second area 2A may include a third pattern area PA-3 and a fourth pattern area PA-4.

The third pattern part PA3 and the fourth pattern part PA4 may be disposed in the second area 2A. The third pattern part P3 and the fourth pattern part P4 may be alternately disposed. In detail, the third pattern part P3 and the fourth pattern part P4 may be alternately disposed while being spaced apart from each other in the second direction 2D.

That is, one fourth pattern part P4 may be disposed between the two third pattern parts P3, and one third pattern part P3 may be disposed between the two fourth pattern parts P4.

The third pattern P3 and the fourth pattern P4 may be disposed in the third pattern area PA-3. In addition, the third pattern P3 or the fourth pattern P4 may be disposed in the fourth pattern area PA-4. In detail, the third pattern P3 may be only disposed in the fourth pattern area PA-4. In more detail, a portion of the third pattern P3 may be only disposed in the fourth pattern area PA-4.

Accordingly, the second area 2A may include a third pattern P3 disposed in the third pattern area PA-3 and a third pattern P3 disposed in the fourth pattern area PA-4.

The third pattern P3 disposed in the fourth pattern area PA-4 may be formed with an open end. That is, one end of the third pattern P3 disposed in the fourth pattern area PA-4 may be opened.

For example, one end of the third pattern P3 disposed in the fourth pattern area PA-4 may be disposed on the same plane as an end of the elastic member 100 in the first direction. In addition, an end overlapping the third pattern P3 among ends of the elastic member 100 in the first direction may be opened.

Accordingly, the elastic member 100 may include a plurality of hinge parts HN which are formed at the end of the elastic member 100 in the first direction perpendicular to the folding axis, and are opened and formed in an area overlapping the third pattern P3 disposed in the fourth pattern area PA-4.

Accordingly, when the elastic member 100 is folded, the second region 2A, which is a folding region, may be easily folded.

Also, the third pattern P3 disposed in the third pattern area PA-3 and the third pattern P3 disposed in the fourth pattern area PA-4 may have different lengths.

That is, in the third pattern P3 may include plurality of inner third patterns IP3 in which both ends in the longitudinal direction of the third pattern are not opened; and plurality of outer third patterns OP3 in which one end open among both ends of the third pattern in the longitudinal direction.

In this case, a length L3 of inner third patterns IP3 and a length L3' of outer third patterns OP3 may be different from each other. In detail, the length L3' of outer third patterns IP3 may be longer than the length L3 of inner third patterns IP3.

When the elastic member 100 is repeatedly folded and unfolded, an external impact may be applied to the open part of one end of the outer third pattern or impurities such as particles may be introduced. Accordingly, the outer third pattern may be more worn than the inner third pattern. Accordingly, in the elastic member according to the embodiment, the outer third pattern may be formed longer than the inner third pattern, and one end may be opened to form the elastic member. Accordingly, it is possible to minimize the transmission of an external shock or the introduction of impurities to the inner third pattern through the outer third pattern. Accordingly, it is possible to minimize the transmission of an external shock or the introduction of impurities to the inner third pattern through the outer third pattern. Accordingly, the elastic member according to the embodiment may have improved folding reliability when repeatedly folding and unfolding.

A width of the fourth pattern area PA-4 may be different from a width OA2 of the overlapping area where the third pattern and the fourth pattern adjacent in the third pattern area overlap in the second direction. In detail, the width W5 of the fourth pattern area may be greater than the width of the overlapping area OA2.

On the other hand, the size of at least one of the third pattern P3 and the fourth pattern P4 disposed in the second area 2A may be different from the size of at least one of the first pattern P1 and the second pattern P2 disposed in the first area 1A. In detail, the size of at least one of the third pattern P3 and the fourth pattern P4 may be larger than the size of the first pattern P1 and the second pattern P2. In more detail, at least one of the lengths L3 and L3' of the third pattern P3 and the length L4 of the fourth pattern P4 may be longer than the length L1 of the first pattern P1 and the length L2 of the second pattern P2.

Also, the opening ratio per unit area of the third pattern area PA-3 may be different from the opening ratio per unit area of the fourth pattern area PA-4. Here, the opening ratio may be defined as an area of the third pattern and/or the fourth pattern formed in the second area.

In detail, the opening ratio per unit area of the third pattern area PA-3 may be greater than an opening ratio per unit area of the fourth pattern area PA-4.

That is, while extending from one end of the elastic member in the first direction to the third pattern area PA-3, the opening ratio per unit area of the elastic member may increase.

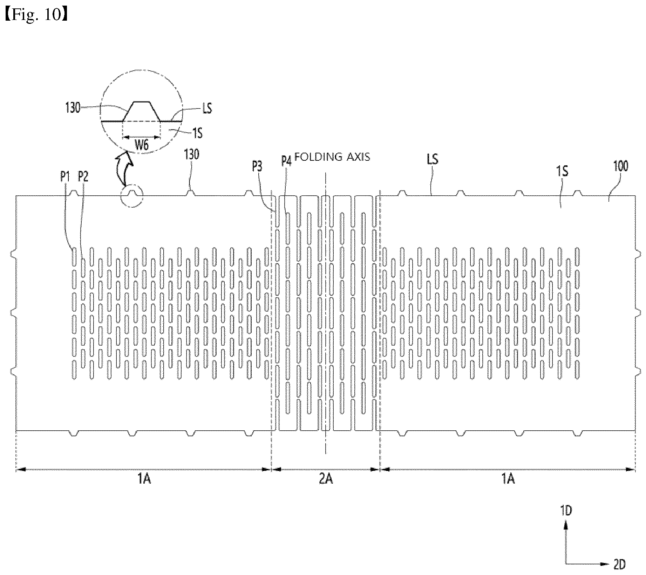

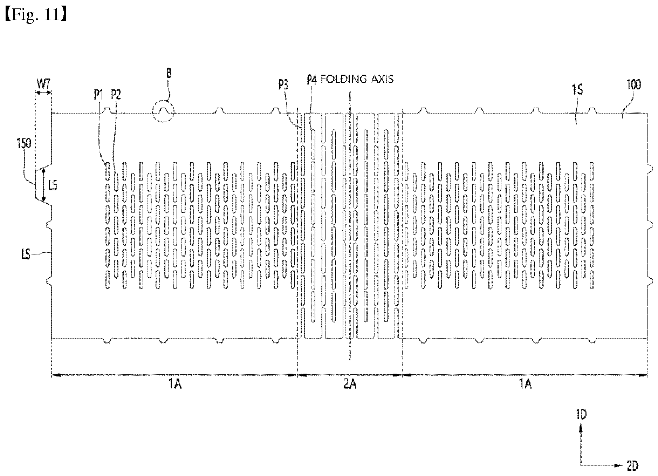

Hereinafter, the protrusion 130 and the reinforcing protrusion 150 of the elastic member 100 according to the embodiment will be described with reference to FIGS. 10 and 11.

Referring to FIG. 10, the protrusion 130 may be disposed in the first area 1A. That is, the protrusion 130 may be disposed in the unfolding area of the elastic member. That is, the protrusion 130 may be disposed on side surfaces LS of the elastic member 100 surrounding the first area 1A of the elastic member 100. At least one protrusion 130 may be disposed on the side surface LS of the elastic member 100. For example, the protrusion 130 may include a plurality of protrusions 130 disposed on the side surface LS of the elastic member 100 and spaced apart from each other.

The protrusion 130 may be disposed to protrude from the side surface LS of the elastic member 100. In detail, the protrusion 130 may be formed in a shape in which the width W6 of the protrusion 130 gradually narrows as it moves away from the side surface LS of the elastic member 100.

The protrusion 130 may be integrally formed with the elastic member 100. That is, the protrusion 130 may be connected to the elastic member 100 on the side surface LS of the elastic member 100, and the protrusion 130 may be integrally formed with the elastic member 100.

The protrusion 130 may be formed in a process of manufacturing the elastic member 100. In detail, the protrusion 130 may serve to easily cut each elastic member 100 when cutting the elastic member 100 having a unit area from a large-area metal substrate.

Accordingly, when the elastic member having a large area is cut into the elastic member having a unit area by the protrusion 130, the elastic member can be easily cut, thereby improving the manufacturing process efficiency of the elastic member.

The number of protrusions 130 disposed on both sides of the elastic member in the first direction 1D may be different from the number of protrusions 130 disposed on both sides of the elastic member in the second direction 2D.

For example, when the first direction 1D of the elastic member is defined as the width direction of the elastic member and the second direction 2D of the elastic member is defined as the longitudinal direction of the elastic member, the number of the protrusions 130 disposed on both sides of the elastic member in the first direction 1D may be greater than the number of the protrusions 130 disposed on both sides of the elastic member in the second direction 2D.

In addition, the protrusions 130 disposed on both sides of the elastic member in the first direction 1D and the protrusions 130 disposed on both sides of the elastic member in the second direction 2D may be disposed to face each other.

For example, when the first direction 1D of the elastic member is defined as the width direction of the elastic member and the second direction 2D of the elastic member is defined as the longitudinal direction of the elastic member, the protrusions 130 disposed on both sides of the elastic member in the first direction 1D may be disposed to overlap an imaginary line parallel to the first direction, the protrusions 130 disposed on both sides of the elastic member in the second direction 2D may be disposed to overlap an imaginary line parallel to the second direction.

Referring to FIG. 11, the elastic member 100 may include a reinforcing protrusion 150.

The reinforcing protrusion 150 may be disposed on the side surface LS of the elastic member 100. For example, the reinforcing protrusion 150 may be disposed on at least one of both sides of the elastic member 100 in the first direction 1D and both sides in the second direction 2D.

For example, the reinforcing protrusion 150 may be disposed on a side surface of the elastic member having a larger width among the non-patterned areas NPA of the first area 1A described above.

The reinforcing protrusion 150 may be integrally formed with the elastic member 100.

The size of the reinforcing protrusion 150 may be different from the size of at least one of the first pattern P1, the second pattern P2, the third pattern P3, and the fourth pattern P4. In detail, the length L5 of the reinforcing protrusion 150 may be greater than at least one of the first pattern P1, the second pattern P2, the third pattern P3, and the fourth pattern P4, and the width W7 of the reinforcing protrusion 150 may be larger than the width of at least one of the first pattern P1, the second pattern P2, the third pattern P3, and the fourth pattern P4.

In addition, the width of the reinforcing protrusion 150 may be greater than the width of the protrusion 130, and the length of the reinforcing protrusion 150 may be longer than the length of the protrusion 130.

Also, the width of the reinforcing protrusion 150 may change from the inside to the outside of the elastic member 100. In detail, the width W7 of the reinforcing protrusion 150 may decrease as it moves away from the side surface LS of the elastic member 100.

The above-described protrusion 130 may not be formed on the reinforcing protrusion 150. In detail, the reinforcing protrusion 150 and the protrusion 130 may be disposed to be spaced apart from each other. That is, on the side surface of the elastic member 100 on which the reinforcing protrusion 150 is formed, the protrusion 130 may be disposed only in an area excluding the area where the reinforcing protrusion 150 is disposed.

Accordingly, it is possible to prevent the reinforcing protrusion 150 from being deformed or damaged due to reduced strength by the protrusion 130.

When the panel or circuit board is disposed on the elastic member 100, the reinforcing protrusion 150 may serve to align the panel or circuit board by being disposed at a position corresponding to the coupling part of the panel or circuit board.

Accordingly, a panel or the like can be easily disposed on the elastic member 100 by the reinforcing protrusion 150, and misalignment of the alignment can be minimized.

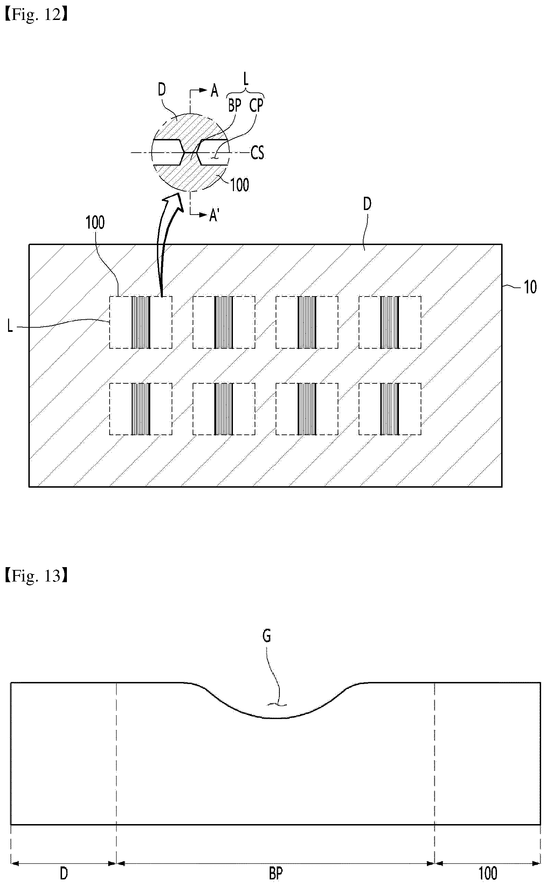

Hereinafter, a process of forming the elastic member according to the embodiment as an elastic member having a unit area and the configuration of the protrusion 130 will be described in detail with reference to FIGS. 12 to 17.

FIG. 12 is a view for explaining a manufacturing process of the elastic member according to the embodiment. Specifically, FIG. 12 is a view for explaining a manufacturing process of an elastic member having a unit area size.

Referring to FIG. 12, first, a large-area metal substrate 10 is prepared. Subsequently, a plurality of elastic members 100 may be formed on the metal substrate 10.

In detail, an elastic member line L for forming the plurality of elastic members 100 may be set on the metal substrate 10, and then, a plurality of pattern parts may be formed inside the elastic member line L. That is, a plurality of pattern parts may be formed in the elastic member line L to form a folding area and an unfolding area.

Accordingly, a plurality of elastic member lines L having a unit area size and dummy parts D disposed outside the elastic member line L may be defined in the metal substrate 10.

That is, each of the elastic member lines L disposed in the region excluding the dummy parts D may be cut to form one elastic member 100 having a size of a unit area.

Then, the elastic member line L may be partially cut. In detail, the elastic member line L may be partially cut to form a cut part CP and a bridge part BP. That is, the cut part CP may be an area where the elastic member line L is cut, and the bridge part CP may be an area where the elastic member line L is not cut.

In detail, the cut part CP of the elastic member line L is defined as an area etched so that one surface and the other surface of the metal substrate 100 penetrate, and the bridge part BP of the elastic member line L may be disposed between the cut parts CP and may be defined as an area connecting a dummy part D and the elastic member 100.

Then, the bridge part BP may be cut from the plurality of elastic members 100 formed on the metal substrate 10 to manufacture the elastic member 100 having a unit area size.

In detail, the bridge part CP is cut along the cut surface CS to separate the elastic member 100 and the dummy part D, and thereby each elastic member 100 may be separated from the metal substrate 100.

The bridge part BP may serve to facilitate cutting of the elastic member 100 and the dummy part D.

That is, the elastic member 100 having a plurality of unit area sizes can be easily separated from the large-area metal substrate 100 through the bridge part BP partially formed on the elastic member line L. Accordingly, the manufacturing process efficiency of the elastic member 100 may be improved.

Meanwhile, since the bridge part BP for facilitating cutting with the dummy part D in the edge region of the elastic member 100 is partially cut, the bridge part BP may partially remain in the cut elastic member 100.

At this time, when the length of the bridge part BP remaining in the process of cutting the bridge part BP becomes too large, when the elastic member 100 is combined with or adhered to another member or pattern, it may be interfered with by the bridge part BP. Accordingly, the efficiency of the bonding or assembly process may be reduced.

The elastic member according to the embodiment controls the shape of the bridge part BP in order to solve the above problems, thereby the length of the bridge part BP control.

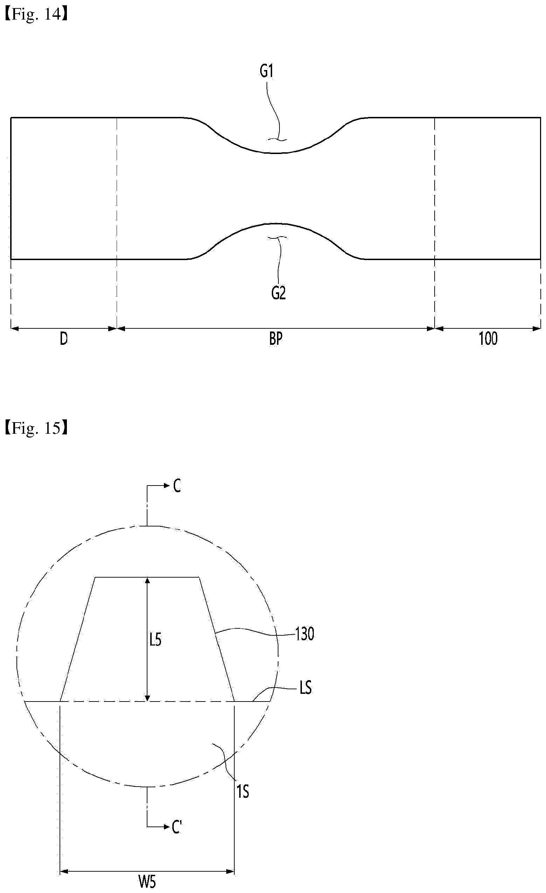

FIGS. 13 and 14 are cross-sectional views of the bridge part BP taken along a region A-A' of FIG. 12.

Referring to FIGS. 13 and 14, the bridge part BP may include a groove. In detail, the bridge part BP may include at least one groove formed on one surface of the bridge part BP and the other surface opposite to the one surface.

For example, referring to FIG. 13, the bridge part BP may include a groove G formed on one surface of the bridge part BP or the other surface opposite to the one surface.

The groove G may be formed by partially etching the bridge part BP.

Alternatively, referring to FIG. 14, the bridge part BP may include a first groove G1 formed on one surface of the bridge part BP and a second groove G2 formed on the other surface opposite to the one surface.

In detail, the first groove G1 and the second groove G2 may be disposed while overlapping in the thickness direction of the bridge part BP. In addition, the first groove (G1) and the second groove (G2) may be disposed to be spaced apart from each other without contacting each other at positions overlapping each other.

Subsequently, the groove area formed in the bridge part BP may be cut using a laser or a blade. In this case, the elastic member 100 may be easily cut from the dummy area D of the metal substrate 10 through the groove previously formed in the bridge part BP.

That is, the cut area of the bridge part BP may be confirmed in advance by the groove formed in the bridge part BP, and the bridge part BP may be easily cut.

Accordingly, the bridge part BP may be easily cut through the groove formed in the bridge part BP. In addition, since the bridge part BP is cut at a desired position, tolerances during the cutting process can be minimized. Accordingly, it is possible to prevent the length of the bridge portion BP from increasing after the elastic member 100 is cut in the dummy region.

Referring to FIG. 15, the protrusion 130 may be disposed to protrude from the side surface LS of the elastic member 100. In detail, the protrusion 130 may be formed in a shape in which the width W5 of the protrusion 130 gradually narrows as it moves away from the side surface LS of the elastic member 100.

The protrusion 130 may be integrally formed with the elastic member 100. That is, the protrusion 130 may be connected to the elastic member 100 on the side surface LS of the elastic member 100, and the protrusion 130 may be integrally formed with the elastic member 100.

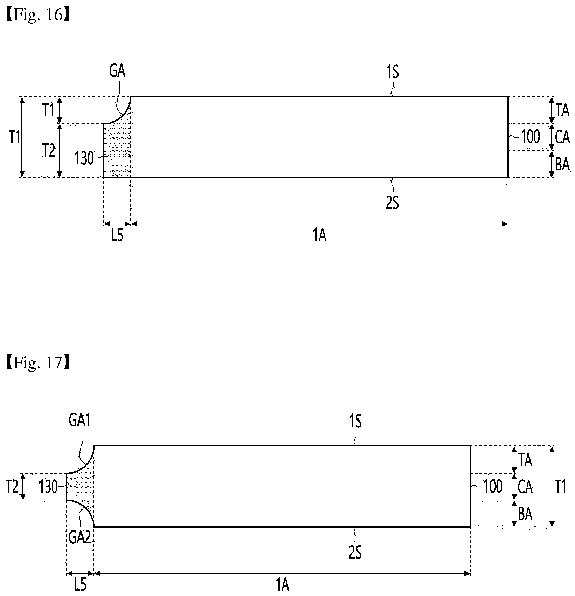

FIGS. 16 and 17 are cross-sectional views taken along the cutting plane of FIG. 15 of the protrusion 130.

Referring to FIGS. 16 and 17, the protrusion 130 may include a groove part. In detail, the protrusion may include a groove part connected to at least one of the first surface 1S and the second surface 2S of the elastic member.

FIG. 16 shows that the protrusion 130 is formed by the groove part GA formed in connection with the first surface 1S of the elastic member 100, the embodiment is not limited thereto, and the groove GA may be formed on the second surface 2S of the elastic member 100, thereby he protrusion 130 may be formed.

For example, when the elastic member 100 is defined as a lower area BA, a central area CA, and an upper area TA whose sizes correspond to each other in the thickness direction of the elastic member 100, the protrusion 130 may be disposed in the lower area BA or the upper area TA of the elastic member 100.

Alternatively, referring to FIG. 17, the protrusion 130 may include a first groove part GA1 and a second groove part GA2. In detail, the protrusion 130 may be formed by the first groove part GA1 connected to the first surface 1S of the elastic member 100 and the second groove part GA2 connected to the second surface 2S of the elastic member 100

Accordingly, when the elastic member 100 is defined as the lower area BA, the central area CA, and the upper area TA whose sizes correspond to each other in the thickness direction of the elastic member 100, the protrusion 130 may be disposed in the central area CA of the elastic member 100.

Alternatively, the protrusion 130 may be disposed on the whole of the central area CA and a part of the lower area BA of the elastic member 100. Alternatively, the protrusion 130 may be disposed on the whole of the central area CA and a part of the upper area TA of the elastic member 100.

A thickness T1 of the protrusion 130 may gradually decrease as it moves away from the first area 1A. In detail, the thickness T1 of the protrusion 130 may gradually decrease as it moves away from the side surface LS of the elastic member 100. Accordingly, the thickness T1 of the end of the protrusion 130 may be smaller than the thickness T2 of the elastic member 100.

The protrusion 130 may be disposed to protrude from the first area 1A of the elastic member 100. In detail, the protrusion 130 may be disposed to extend to a predetermined length in the first area 1A of the elastic member 100.

In detail, the length L5 of the protrusion 130 may be defined as a distance from the end of the elastic member 100 to the end of the protrusion 130. In more detail, the length L5 of the protrusion 130 may be defined as a distance from a portion where the elastic member 100 and the protrusion 130 are connected to an end of the protrusion 130.

The length L5 of the protrusion 130 may be smaller than a thickness T1 of the elastic member 100. In detail, the length L5 of the protrusion 130 may be 2/3 or less of the thickness T1 of the elastic member 100. In more detail, the length L5 of the protrusion 130 may be 1/3 or less of the thickness T1 of the elastic member 100.

For example, the length L5 of the protrusion 130 may be formed to be 200 µm or less. In detail, the length L5 of the protrusion 130 may be formed to be 150 µm or less. In more detail, the length L5 of the protrusion 130 may be formed to a length of 100 µm or less.

When the length L5 of the protrusion 130 exceeds 200 µm, the length of the protrusion is increased too much, whereby the protrusion interferes with the coupling in the process of coupling the elastic member with other members, thereby the process efficiency may be reduced.

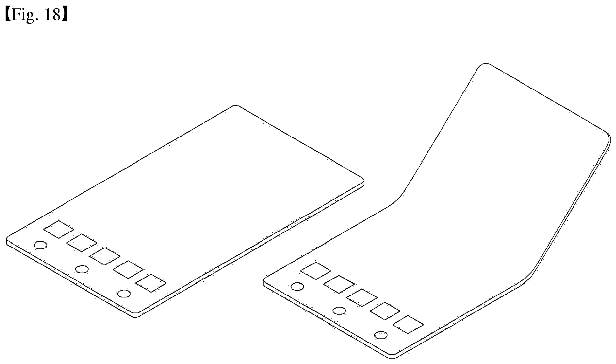

FIG. 18 is a view for describing an example in which a elastic member according to embodiments is applied.

Referring to FIG. 18, the elastic member according to the embodiments may be applied to a flexible display device that displays a display.

For example, the elastic member according to the embodiments may be applied to a flexible display device such as a mobile phone or a tablet.

Such the elastic member may be applied to flexible display devices such as a mobile phone, a tablet, and the like that are flexible, bent or folded.

The elastic member is applied to the flexible display devices such as the mobile phone, the tablet, and the like that are flexible, bent or folded and may improve the reliability of the flexible display device by improving the folding reliability in the display device that is repeatedly folded or restored.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. An elastic member comprising a first surface and the second surface opposite to the first surface; and a first area and a second area,
wherein the first area includes a first pattern part in which a plurality of first patterns is disposed to extend in a first direction; and a second pattern part in which a plurality of second patterns is disposed extending in the first direction and partially overlapping the first pattern part in a second direction different from the first direction,
wherein the first area includes a pattern area in which the first pattern part and the second pattern part are formed; and a non-patterned area disposed outside the pattern region and in which the first pattern part and the second pattern part are not formed.

2. The elastic member of claim 1, wherein a width of the non-patterned area is greater than a maximum length of at least one of the first pattern and the second pattern.

3. The elastic member of claim 1, wherein the second area includes a third pattern part in which a plurality of third patterns is disposed to extend in a first direction; and a fourth pattern part in which a plurality of fourth patterns is disposed extending in the first direction and partially overlapping the third pattern part in a second direction different from the first direction,
wherein a width of the non-patterned area is greater than a maximum length of the third pattern or a maximum length of the fourth pattern.

4. The elastic member of claim 1, wherein 1 width of the non-patterned area is greater than or equal to 5 times greater than a maximum length of at least one of the first pattern and the second pattern.

5. The elastic member of claim 1, wherein the pattern area includes a first pattern area and a second pattern area,
wherein the second pattern area is disposed between the first pattern area and the non-patterned area,
wherein an opening ratio per unit area of the first pattern area and the second pattern area is different.

6. The elastic member of claim 5, wherein the opening ratio per unit area of the first pattern area is greater than the opening ratio per unit area of the second pattern area.

7. The elastic member of claim 5, wherein a width of the second pattern area is smaller than a maximum length of at least one of the first pattern and the second pattern, and is greater than a maximum width of at least one of the first pattern and the second pattern.

8. The elastic member of claim 3, wherein the second area includes a third pattern area in which the plurality of third patterns and the plurality of fourth patterns are disposed; and a fourth pattern area in which the third pattern is disposed.

9. The elastic member of claim 8, wherein one end of the third pattern disposed in the fourth pattern area is open.

10. The elastic member of claim 1, further comprising a protrusion disposing on at least one side of the side surface of the elastic member and protruding from the side surface of the elastic member,
wherein a width of the protrusion decreases as it moves away from the side surface of the elastic member,
wherein the protrusion portion includes a groove part connected to at least one of the first surface and the second surface of the elastic member.
